# EUROPEAN PATENT APPLICATION

(11) **EP 1 832 229 A1**
(43) Date of publication of application: **12.09.2007**
(21) Application number: 04822523.9
(22) Date of filing: 30.11.2004
(51) Int. Cl.: A61B 5/055, G01R 33/48

(54) **MAGNETIC RESONANCE IMAGING METHOD AND MAGNETIC RESONANCE IMAGING APPARATUS**

(71) Applicant: Hamano Life Science Research Foundation, Shinjuku-ku, Tokyo 160-0015 (JP)
(72) Inventor: KAMEI, Hirotake c/o Ogawa Laboratories, Shinjuku-ku, Tokyo, 1600015 (JP)
(74) Representative: Baronetzky, Klaus
(86) International application number: PCT/JP2004/017812
(87) International publication number: WO 2006/059378

(57) **Abstract**

A magnetic resonance imaging method and a magnetic resonance imaging apparatus are provided, which can obtain a high-quality image at high speed without obstructions, such as an artifact by a distribution of a magnetic susceptibility and a myoneural stimulus by an eddy current using only radio frequency magnetic field (rotating magnetic field) gradients so as to obtain positional information.

This magnetic resonance imaging apparatus comprises a phase encoding coil (2x) and a frequency encoding coil (2y) for applying radio frequency magnetic field gradient pulses to a sample, placed in a static magnetic field, respectively, in two axial directions which do not include a static magnetic field direction among three axial directions being mutually orthogonal, which include the direction of the static magnetic field as one axis, a detector (21) for detecting a transient nutation signal generated in the sample, the transient nutation signal being included in the radio frequency magnetic field gradient pulse obtained through the frequency encoding coil (2y), and a storage and arithmetic unit (24) for obtaining a magnetic resonance image of the sample by storing and arithmetically operating the signal obtained through the detector.

## Description

### Technical field

The present invention relates to a magnetic resonance imaging method and a magnetic resonance imaging apparatus which visualize invisible information inside a living body or a material using a magnetic resonance phenomenon.

### Background Art

In a magnetic resonance imaging, a magnetic resonance signal has a frequency, a phase, and signal strength as information. Although information regarding a position can be encoded in any of these, a best policy does not encode positional information in signal strength. The purpose of the magnetic resonance imaging is, however, to produce spatial distribution of signal strength. Then, generally, positional information is encoded in the frequency and the phase.

A conventional magnetic resonance imaging uses a static magnetic field gradient so as to obtain positional information. For example, although a magnetic resonance imaging which used a radio frequency magnetic field gradient only for phase encoding in a laboratory coordinate system is proposed, this method uses the static magnetic field gradient for signal observation (non-patent document 1).

Non-patent document 1: D.I. Hoult, "Rotating Frame Zeugmatorgraphy", Journal of Magnetic Resonance 33, 183-197 (1979)

When a static magnetic field gradient is used for signal observation as of conventional, disorder of an image by difference between magnetic susceptibilities arises in a site where magnetic susceptibilities are greatly different such as a site where a living body tissue and air are in contact, and hence, it is easy to obtain incorrect information. This artifact may be unable to perform MRI diagnosis of a lower part of a scull or lungs correctly in a usual magnetic resonance imaging. In addition, although a static magnetic field gradient is turned on and off at high speed in a high-speed imaging, since an eddy current arises at this time and a nervous system and muscular tissue are stimulated in a living organism, acceleration and achievement of high resolution of an image are limited.

Hence, an object of the present invention is to provide a magnetic resonance imaging method and a magnetic resonance imaging apparatus which can obtain a high-quality image at high speed without obstructions, such as an artifact by a distribution of a magnetic susceptibility and a myoneural stimulus by an eddy current using only radio frequency magnetic field (rotating magnetic field) gradients so as to obtain positional information.

### Disclosure of the Invention

The above-mentioned object is achieved by a magnetic resonance imaging method comprising sequentially applying radio frequency magnetic field gradient pulses to a sample placed in a static magnetic field, in two axial directions which do not include a direction of the static magnetic field among three axial directions being mutually orthogonal, which include the direction of the static magnetic field as one axis, and obtaining a magnetic resonance image of the sample by using a transient nutation signal generated in the sample during the application of the radio frequency magnetic field gradient pulse applied for the last time.

Furthermore, a magnetic resonance image of the above-mentioned sample can be also obtained by sequentially applying radio frequency magnetic field gradient pulses in three axial directions which include the above-mentioned static magnetic field direction and which are mutually orthogonal, and using a transient nutation signal generated in the above-mentioned sample during an application of the radio frequency magnetic field gradient pulse applied at an end of that time. Furthermore, the radio frequency magnetic field gradient pulses are sequentially applied in three axial directions being mutually orthogonal, which include the direction of the static magnetic field, and a magnetic resonance image of the sample can be also obtained by using a transient nutation signal generated in the sample during the application of the radio frequency magnetic field gradient pulse applied for the last time.

In addition, a magnetic resonance imaging apparatus according to the present invention comprises a phase encoding coil and a frequency encoding coil for applying radio frequency magnetic field gradient pulses to a sample placed in a static magnetic field, respectively, in two axial directions which do not include a direction of the static magnetic field among three axial directions being mutually orthogonal, which include the direction of the static magnetic field as one axis, a detector for detecting a transient nutation signal generated in the sample, the transient nutation signal being included in the radio frequency magnetic field gradient pulse obtained through the frequency encoding coil, and a storage and arithmetic unit for obtaining a magnetic resonance image of the sample by storing and arithmetically operating the signal obtained through the detector. Furthermore, it can also comprise two phase encoding coils and one frequency encoding coil for applying radio frequency magnetic field gradient pulses, respectively, in three axial directions being mutually orthogonal, which include the static magnetic field direction. In this case, when the radio frequency magnetic field gradient pulse is applied to one of the phase encoding coils and the frequency encoding coil, it is preferable to shift a resonant frequency of the remaining coil.

Thereby, it is possible to obtain a two-dimensional or three-dimensional magnetic resonance image of the sample.

According to the present invention, it is possible to obtain a magnetic resonance imaging method and a magnetic resonance imaging apparatus which can obtain a high-quality image at high speed without obstructions, such as an artifact by a distribution of a magnetic susceptibility and a myoneural stimulus by an eddy current by measuring a transient nutation signal using only radio frequency magnetic field gradients as magnetic field gradients for encoding positional information.

### Brief Description of the Drawings

Figure 1 is a graph illustrating an example of magnetizing behavior in a rotating coordinate system;
Figure 2(a) is a chart illustrating an example of a radio frequency pulse which generates a rotating magnetic field (radio frequency magnetic field) B₁, and Figure 2(b) is a chart illustrating an example of a transient nutation signal;
Figure 3 is a diagram illustrating one example of a magnetic resonance imaging apparatus according to the present invention;
Figure 4 is a drawing illustrating a structural example of radio frequency magnetic field gradient coils in a two-dimensional imaging method;
Figure 5 includes charts illustrating a pulse sequence in the two-dimensional imaging method, Figure 5(a) is a chart illustrating an x gradient pulse Gx, Figure 5(b) is a chart illustrating a y gradient pulse Gy, and Figure 5(c) is a chart illustrating a transient nutation signal TN;
Figure 6 is a diagram illustrating an example of a balanced bridge circuit using a differential transformer as a transient nutation signal detector;
Figure 7 is a diagram illustrating another example of the magnetic resonance imaging apparatus according to the present invention;
Figure 8 is a drawing illustrating a structural example of radio frequency magnetic field gradient coils in a three-dimensional imaging method; and
Figure 9 shows charts illustrating a pulse sequence in the three-dimensional imaging method, Figure 9(a) is a chart illustrating an x gradient pulse Gx, Figure 9(b) is a chart illustrating a z gradient pulse Gz, Figure 9(c) is a chart illustrating a y gradient pulse Gy, and Figure 9(d) is a chart illustrating a transient nutation signal TN.

### Description of Symbols

- 1:: magnet
- 2x, 2y, 2z:: radio frequency magnetic field gradient coil
- 3:: sample
- 10:: radio frequency oscillator
- 11:: pulse generator
- 12x, 12y, 12z:: modulator
- 13:: phase shifter
- 14x, 14y, 14z:: radio frequency amplifier
- 21:: detector
- 22:: phase sensitive detector
- 23:: amplifier
- 24:: storage and arithmetic unit
- 25:: display unit

### Best Mode for Carrying Out the Invention

Hereafter, although an example of the present invention will be described, a principle of the present invention will be first described before that.

The present invention measures a transient nutation signal using only radio frequency magnetic field gradients as magnetic field gradients for encoding positional information. Thereby, it is possible to obtain a high-quality image at high speed without obstructions such as an artifact by a distribution of a magnetic susceptibility and a myoneural stimulus by an eddy current. A transient nutation is described, for example, in Abragam, "Principles of Nuclear Magnetism", Clarendon Press, Oxford, 1961, pp.68-70.

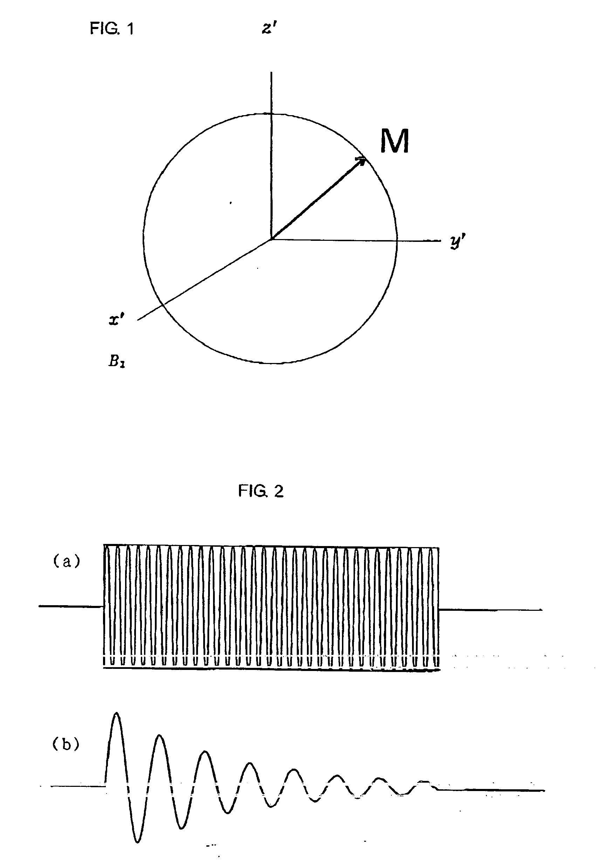

When a uniform static magnetic field B₀ is applied to a sample of a measuring object, nuclear spins or electron spins in the sample perform a precession with centering on a direction of the static magnetic field (z). Let a gyromagnetic ratio of the nuclear spins or electron spins in the sample be γ, and an angular frequency ω₀ of this motion is given by ω₀ = γB₀. When a rotating magnetic field B₁ rotating within a plane (x, y) perpendicular to this static magnetic field B₀ is applied, nuclear magnetic moment M performs a precession with centering on an effective magnetic field (magnitude B_{eff} = (1/γ)[(ω₀ - ω)² + ω₁²]^{1/2}) of a synthesized vector of the static magnetic field B₀ and the rotating magnetic field B₁. This is called a nutation. This aspect can be easily understood by considering it in a rotating coordinate system rotating at ω₀. Figure 1 is a graph illustrating an example of magnetizing behavior in the rotating coordinate system. When an effective magnetic field which is acting on spins in the rotating coordinate system is only B₁, that is, when it is in resonance (ω = ω₀), magnetic moment M rotates at an angular frequency of ω₁ = γB₁ with centering on a direction of the rotating magnetic field B₁ (x').

Figure 2(a) is a chart illustrating an example of a radio frequency pulse which generates a rotating magnetic field (radio frequency magnetic field) B₁, and Figure 2(b) is a chart illustrating an example of a transient nutation signal. As shown in Figure 2, the nutation signal is observed during an application of the rotating magnetic field (radio frequency magnetic field) B₁, the angular frequency (nutation frequency) ω₁ of the nutation in a resonating point is ω₁ = γB₁ as described above, and as for a time constant Tₙ of attenuation, with letting longitudinal relaxation time (spin-lattice relaxation time) be T₁, and letting transverse relaxation time (spin-spin relaxation time) be T₂, when uniformity of the radio frequency magnetic field B₁ is high enough, it is 2/Tₙ = (1/T₁) + (1/T₂).

### (Example 1)

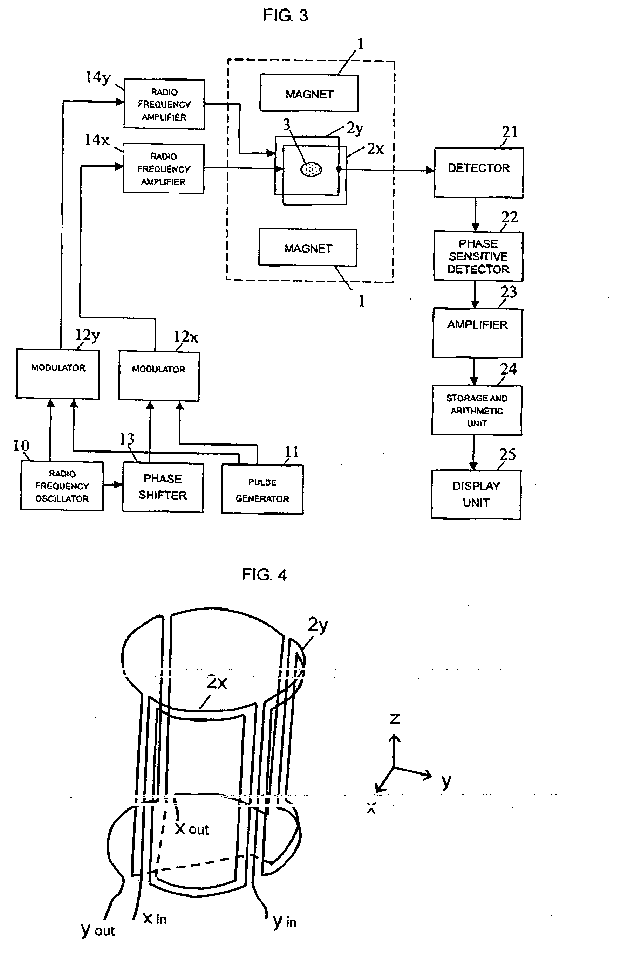

Figure 3 is a diagram illustrating one example of a magnetic resonance imaging apparatus according to the present invention. This apparatus indicates a case of two-dimensional measurement, and includes a magnet 1 generating a static magnetic field B₀, and two radio frequency (rotating) magnetic field gradient coils 2x and 2y installed in a position where the static magnetic field exists, as illustrated. A sample 3 which is a measuring object is arranged in an approximate center of these. The two radio frequency (rotating) magnetic field gradient coils 2x and 2y are arranged so that directions of radio frequency magnetic fields which they generate may be mutually orthogonal and may be orthogonal to the static magnetic field. Among these, one of the radio frequency magnetic field gradient coils is used as a phase encoding coil, and another radio frequency magnetic field gradient coil is used as a frequency encoding coil.

Figure 4 is a drawing illustrating a structural example of radio frequency magnetic field gradient coils in a two-dimensional imaging method. In this example, the static magnetic field is arranged as a z-axis, the phase encoding coil is done as an x-axis, and the frequency encoding coil is done as a y-axis. In this case, the phase encoding coil 2x is an x gradient coil, and the frequency encoding coil 2y is a y gradient coil. Let a center of these be an origin O. In Figure 4, the x gradient coil 2x is constructed of a two-turn saddle type coil, and a one-turn saddle type coil opposite to this, that is, a pair of saddle type coils numbers of windings of which are asymmetric. In the figure, dotted lines in a lower portion are lead wires which connect the pair of saddle type coils. The y gradient coil 2y is also the same pair of saddle type coils. Lines of magnetic force of a magnetic field gradient which the x gradient coil 2x and the y gradient coil 2y generate are mutually orthogonal.

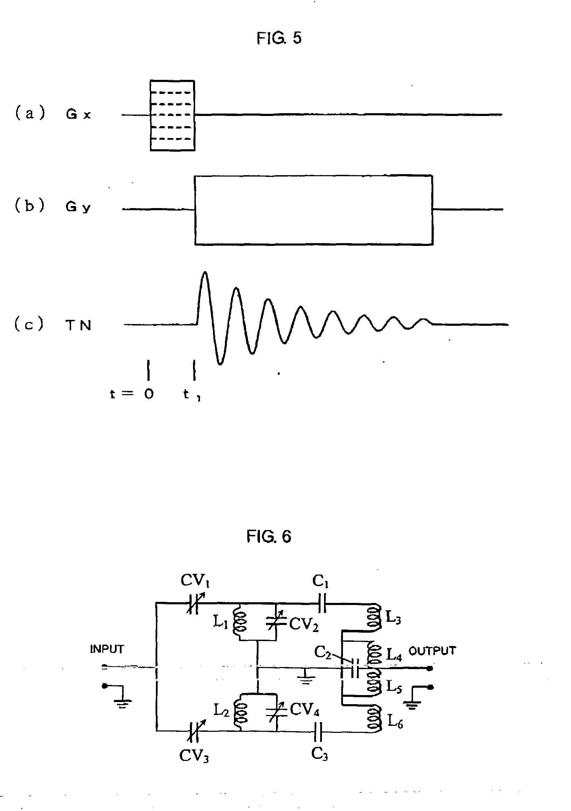

Figure 5 includes charts illustrating a pulse sequence in the two-dimensional imaging method, Figure 5(a) is a chart illustrating an x gradient pulse Gx, Figure 5(b) is a chart illustrating a y gradient pulse Gy, and Figure 5(c) is a chart illustrating a transient nutation signal TN. As illustrated, the radio frequency pulse Gx (x gradient pulse) at a resonance frequency is applied to the phase encoding coil 2x at time t = 0. While the x gradient pulse is removed at time t = t₁, the radio frequency pulse Gy (y gradient pulse) for signal detection is applied to the frequency encoding coil 2y for a transient nutation signal to be observed. Phases of the phase encoding pulse GX and the frequency encoding pulse Gy are made to shift by 90° or odd times of 90°.

Next, with returning to Figure 3, generation means of the above-described x gradient pulse GX and y gradient pulse Gy will be described. In Figure 3, a radio frequency oscillator 10 oscillates a radio frequency signal, and a pulse generator 11 generates pulse signals. Modulators 12x and 12y modulate radio frequency signals with pulse signals and output them. A radio frequency signal whose phase is shifted by, for example, 90° through a phase shifter 13 from the radio frequency oscillator 10 is sent to the modulator 12x. Outputs of the modulators 12x and 12y are amplified by the radio frequency amplifiers 14x and 14y respectively, and are supplied to the radio frequency magnetic field gradient coils 2x and 2y as the x gradient pulse Gx and the y gradient pulse Gy as illustrated in Figure 5. Thereby, the transient nutation signal TN is observed. Next, this respect will be described in detail.

Since it is easy to describe behavior toward macroscopic magnetization in magnetic resonance using a rotating coordinate system of a resonance frequency, hereafter, the rotating coordinate system will be described. When a phase encoding pulse (x gradient pulse) is applied to the x' axis at time t = 0, the macroscopic magnetization rotates around the x' axis at angular frequencies proportional to radio frequency magnetic field intensity (magnetic flux density) in respective positions placed. When not only the phase encoding pulse is removed at time t = t₁ but also the frequency encoding pulse (y gradient pulse) shifted by 90° or odd times of 90° from the phase encoding pulse is applied to the y-axis of the laboratory coordinate system, it means that a radio frequency magnetic field having a gradient in a y-axial direction is applied to x', and hence, the magnetization continuously rotates around the x' axis at angular frequencies proportional to the radio frequency magnetic field intensity of the frequency encoding pulse in the respective positions placed. A transient nutation signal is observed from time t = t₁. This signal is observed by a transient nutation signal detector 21.

The transient nutation signal is included in the frequency encoding pulse with large amplitude as a very weak signal. For this reason, since an amplifier system is saturated when the frequency encoding pulse is amplified directly, the transient nutation signal cannot be observed. Then, in order to remove an unnecessary radio frequency pulse and to detect only a signal, for example, a bridge circuit or a differential circuit is used as the transient nutation signal detector 21.

Figure 6 is a diagram illustrating an example of a symmetrical bridge circuit using a differential transformer as a transient nutation signal detector. In Figure 6, reference numerals CV₁ to CV₄ denote variable capacitors, reference numerals C₁ to C₃ denote capacitors, and reference numerals L₁ to L₆ denote coils. This bridge circuit inputs the radio frequency pulse applied to the frequency encoding coil, subtracts a radio frequency pulse having the same amplitude as this, and takes out only a transient nutation signal included in the frequency encoding pulse as an output. Although this example illustrates a Pake's bridge circuit, it is not limited to this, but, for example, Torrey's symmetrical bridge circuit, and an Anderson's asymmetrical bridge circuit can be also used.

In this way, the transient nutation signal detector 21 can remove the applied radio frequency pulse and can detect only the transient nutation signal. Positional information in an x-axial direction is encoded in a phase of the transient nutation signal observed, and positional information in a y-axial direction is encoded in a frequency. The transient nutation signal is transferred to the storage and arithmetic unit 24 through the phase sensitive detector 22 and the amplifier 23. A series of measurement is performed by systematically changing amplitude of the phase encoding pulse, and the transient nutation signal in which the positional information in the x-axial direction is encoded as phase information is stored in the storage and arithmetic unit 24. At this time, it is also sufficient to systematically changing applying time, that is, t₁ by fixing the amplitude of the phase encoding pulse. In the storage and arithmetic unit 24, a two-dimensional magnetic resonance image can be obtained by performing two-dimensional Fourier transform processing of the taken-in signal by the same method as a usual Fourier transformation imaging. This can be displayed on the display apparatus 25.

A static magnetic field gradient and selective excitation can be used for cut-out of a plane perpendicular to the z-axis similarly to a usual magnetic resonance imaging. When applying the radio frequency pulse to one of two gradient pulses, it is possible to avoid mutual interference among respective coils by shifting resonant frequencies of other coils from the frequency of the radio frequency pulse, that is, the resonance frequency.

### (Example 2)

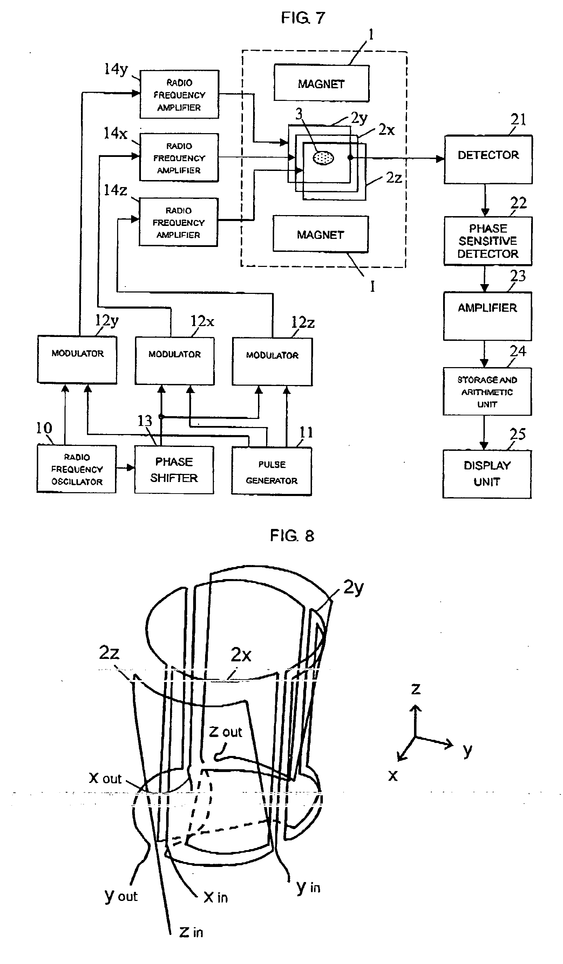

Figure 7 is a diagram illustrating another example of the magnetic resonance imaging apparatus according to the present invention. This apparatus indicates a case of three-dimensional measurement, and includes a magnet 1 generating a static magnetic field B₀, and three radio frequency (rotating) magnetic field gradient coils 2x, 2y, and 2z installed in a position where the static magnetic field exists, as illustrated. A sample 3 which is a measuring object is arranged in an approximate center of these.

Figure 8 is a drawing illustrating a structural example of radio frequency magnetic field gradient coils in a three-dimensional imaging method. In Figure 8, a z gradient coil 2z is a pair of saddle type coils with the same numbers of windings. Although its axis is the same as that of the x gradient coil, an upper coil-to-coil distance spreads in comparison with a lower portion of drawing. In addition, an upper side is longer than a lower side, that is, what the coils envelop becomes an inverted cone instead of a cylinder. Inversion of top and bottom may be also sufficient. In this way, in the three-dimensional imaging method, although the z gradient coil 2z for a radio frequency magnetic field in the z direction is necessary besides the x gradient coil 2x and the y gradient coil 2y, it is not possible to excite a spin system from a principle of magnetic resonance when the axis of this gradient coil is made into the z-axial direction. In this example, a radio frequency magnetic field gradient with the gradient in the z-axial direction is generated by a Helmholtz type coil in a broad sense which centers around the x or y axial direction, that is, a coil which is a pair of coils, and in which a gap between the two coils are changed along with the z-axis.

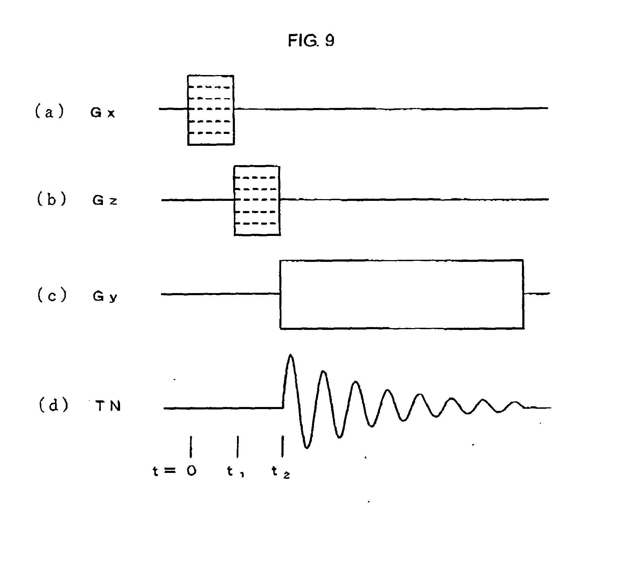

Figure 9 shows charts illustrating a pulse sequence in the three-dimensional imaging method, Figure 9(a) is a chart illustrating an x gradient pulse Gx, Figure 9(b) is a chart illustrating a z gradient pulse Gz, Figure 9(c) is a chart illustrating a y gradient pulse Gy, and Figure 9(d) is a chart illustrating a transient nutation signal TN. when the axis of the z gradient coil is set in the x-axial direction, a phase of a radio frequency magnetic field is made the same as that of the x gradient pulse, and when it is installed in the y-axial direction, it is made the same phase as that of the y gradient pulse-Phases of the x gradient pulse and the y gradient pulse are made to shift by 90° or odd times of 90°. What is necessary is just to make any one of x, y, and z gradient pulses into a frequency encoding pulse, and to make the two remainings into a phase encoding pulse, and their combination is free.

Next, with returning to Figure 7, generation means of the above-described x gradient pulse Gx, y gradient pulse Gy, and z gradient pulse Gz will be described. In Figure 7, a radio frequency oscillator 10 oscillates a radio frequency signal, and a pulse generator 11 generates pulse signals. Modulators 12x, 12y, and 12z modulate radio frequency signals with pulse signals and output them. A radio frequency signal whose phase is shifted by, for example, 90° through a phase shifter 13 from the radio frequency oscillator 10 is sent to the modulators 12x and 12z. Outputs of the modulators 12x, 12y, and 12z are amplified by the radio frequency amplifiers 14x, 14y, and 14z respectively, and are supplied to the radio frequency magnetic field gradient coils 2x, 2y, and 2z as the x gradient pulse GX, the y gradient pulse Gy and the z gradient pulse Gz as illustrated in Figure 9. Thereby, the transient nutation signal TN is observed. Next, this respect will be described in detail.

In this example, macroscopic magnetizing behavior in a rotating coordinate system at the time of performing arrangement so as to make the x and z gradient pulses into a phase encoding pulse, and to make the z gradient coil center around the x-axial direction and making the y gradient pulse into the frequency encoding pulse will be described. When the x gradient pulse is applied to the x' axis at time t = 0, the macroscopic magnetization rotates around the x' axis at angular frequencies proportional to radio frequency magnetic field intensity in respective positions placed. When not only removing the x gradient pulse at time t = t₁ but also applying the z gradient pulse, the macroscopic magnetization which has been rotating in proportion to the radio frequency magnetic field intensity of the x gradient continues rotation at an angular frequency proportional to the radio frequency magnetic field intensity of the z gradient. When not only stopping the z gradient pulse at t = t₂, but also applying the y gradient pulse with phase difference of 90° from the x and z gradient pulses, the macroscopic magnetization continues rotation around the x' axis. When the transient nutation signal at this time is observed, the positional information in the x- and z-axial direction is encoded in a phase of the signal, and the positional information in the y-axial direction is encoded in its frequency. The transient nutation signal at the time of applying the y gradient pulse is observed by the transient nutation signal detector 21 mentioned above.

The transient nutation signal is transferred to the storage and arithmetic unit 24 through the phase sensitive detector 22 and the amplifier 23. A series of transient nutation signals at the time of applying the y gradient pulse are observed by systematically changing amplitude or applying time of the x and z gradient pulses, and this is stored in the storage and arithmetic unit 24. In the storage and arithmetic unit 24, a three-dimensional magnetic resonance image can be obtained by performing three-dimensional Fourier transform processing of the taken-in signal by the same method as a usual Fourier transformation imaging. This can be displayed on the display apparatus 25.

When applying the radio frequency pulse to one of three gradient pulses, it is possible to avoid mutual interference among respective coils by shifting resonant frequencies of other two coils from the frequency of the radio frequency pulse, that is, the resonance frequency.

### Industrial Applicability

The present invention enables visualization of clearer living body and inter-substance information by the high-speed magnetic resonance imaging without artifact by a distribution of a magnetic susceptibility, a biostimulus by an eddy current, and the like, and can contribute to development of wide fields, such as medicine, medical care, bionics, and physical properties research.

## Claims

1. A magnetic resonance imaging method comprising:
sequentially applying radio frequency magnetic field gradient pulses to a sample placed in a static magnetic field, in two axial directions which do not include a direction of the static magnetic field among three axial directions being mutually orthogonal, which include the direction of the static magnetic field as one axis; and
obtaining a magnetic resonance image of the sample by using a transient nutation signal generated in the sample during the application of the radio frequency magnetic field gradient pulse applied for the last time.

2. The magnetic resonance imaging method according to claim 1, comprising:
sequentially applying the radio frequency magnetic field gradient pulses in three axial directions being mutually orthogonal, which include the direction of the static magnetic field; and
obtaining a magnetic resonance image of the sample by using a transient nutation signal generated in the sample during the application of the radio frequency magnetic field gradient pulse applied for the last time.

3. A magnetic resonance imaging apparatus comprising:
a phase encoding coil and a frequency encoding coil for applying radio frequency magnetic field gradient pulses to a sample placed in a static magnetic field, respectively, in two axial directions which do not include a direction of the static magnetic field among three axial directions being mutually orthogonal, which include the direction of the static magnetic field as one axis; a detector for detecting a transient nutation signal generated in the sample, the transient nutation signal being included in the radio frequency magnetic field gradient pulse obtained through the frequency encoding coil; and a storage and arithmetic unit for obtaining a magnetic resonance image of the sample by storing and arithmetically operating the signal obtained through the detector.

4. The magnetic resonance imaging apparatus according to claim 3, comprising two phase encoding coils and one frequency encoding coil for applying radio frequency magnetic field gradient pulses, respectively, in three axial directions being mutually orthogonal, which include the static magnetic field direction.

5. The magnetic resonance imaging apparatus according to claim 3 or 4, wherein, when the radio frequency magnetic field gradient pulse is applied to one of the phase encoding coils and the frequency encoding coil, a resonant frequency of the remaining coil is shifted.
